# EUROPEAN PATENT APPLICATION

(11) **EP 4 687 409 A1**
(43) Date of publication of application: **04.02.2026**
(21) Application number: 25189276.6
(22) Date of filing: 14.07.2025
(51) Int. Cl.: H10W 74/40, H10W 74/10, H10W 29/00, H10D 1/64

(54) **ELECTRONIC DEVICE WITH IMPROVED RELIABILITY**

(30) Priority: 30.07.2024 IT 202400017716
(71) Applicant: STMicroelectronics International N.V., 1228 Plan-les-Ouates, Geneva (CH)
(72) Inventor: BELLOCCHI, Gabriele, 95124 CATANIA (IT); RASCUNA', Simone, 95129 CATANIA (IT); PUGLISI, Valeria, 95125 CATANIA (IT)
(74) Representative: Studio Torta S.p.A.

(57) **Abstract**

Electronic device (50) comprising: a semiconductor body (53) of Silicon Carbide, having a surface (53a) having a first portion (55') of the surface (53a) that defines an active region (54) of the electronic device (50) and a second portion (55") of the surface (53a) that is external to the active region (54); a metallization (58) extending on the first portion (55') of the surface (53a) of the semiconductor body (53); a passivation layer (69) extending on part of the metallization (58); and an adhesion layer (76), based on one or more carbon allotropes, extending on the passivation layer (69).

## Description

### TECHNICAL FIELD

The present invention relates to an electronic device with improved reliability, in detail a device based on Silicon Carbide. In particular, it relates to an electronic device and to a manufacturing process of the electronic device.

### BACKGROUND

Silicon Carbide (SiC) is attracting considerable interest in the semiconductor industry, in particular for manufacturing electronic components such as diodes or transistors, especially for power applications.

Electronic devices formed in a substrate of silicon carbide, in its different polytypes (e.g., 3C-SiC, 4H-SiC, 6H-SiC), have numerous advantages such as low output resistance in conduction, low leakage current, resistance to high operating temperatures and high operating frequencies.

However, the development and manufacture of SiC-based electronic devices are limited by factors such as the electrical and mechanical properties of passivation layers (comprised in such electronic devices and, for example, extending on SiC semiconductor bodies of electronic devices). In particular, it is known to form passivation layers using polymeric materials (e.g., polyimide) that allow to withstand high operating temperatures of the electronic devices and have high dielectric strength (e.g. greater than 400 kV/mm). In detail, the high dielectric strength of polymeric materials ensures that the passivation layers withstand high electric fields, and therefore high potential differences thereacross, without undergoing electrical breakdown, and therefore without becoming electrically conductive.

However, polymeric materials have high coefficients of thermal expansion ("CTEs") (e.g., CTE=43e⁻⁶ 1/K for the Polybenzobisoxazole material, or "PIX"), and this causes issues of adhesion of the passivation layer to the SiC, which instead has a much lower coefficient of thermal expansion (CTE=3.8e⁻⁶ 1/K).

In particular, such adhesion issues between the passivation layer and the SiC may arise during thermal cycling tests (e.g., performed between about -50°C and about +150°C) or during use of the electronic device, when the latter is subject to high temperature excursions (e.g., it is subject to operating temperature differences equal to, or greater than, about 200°C). Due to the high difference in CTE between the passivation layer and the SiC, such high thermal excursions generate mechanical stresses at an interface between the passivation layer and the SiC, which may lead to a(n) (at least partial) delamination of the passivation layer with respect to the SiC semiconductor body.

If this delamination were sufficiently extended (e.g., such that no portion of the passivation layer were interposed between two metallizations of the electronic device set to different potentials, which are therefore separated from each other only by air), electric discharges might generate at this interface, leading to damage of the same electronic device. In particular, the risk of damaging the electronic device increases when the latter is used in reverse bias conditions, due to the high voltage difference (e.g., greater than 1000 V) to withstand.

The risk of delamination is even more accentuated in current devices due to the presence of an additional protection layer above the passivation layer. This protection layer, used to protect the electronic device when inserted into a package, is generally of a carbon-based resin, such as for example Bakelite. This resin has a coefficient of thermal expansion not too far from that of the passivation material (e.g., equal to about 7 ppm/°C for the resin and equal to about 67 ppm/°C for the passivation material) and a thickness that is generally greater than that of the passivation layer. As a result, during thermal cycling tests or during use of the electronic device when the latter is subject to high thermal excursions, the protection layer deforms similarly to the passivation layer. This deformation of the protection layer is transmitted to the passivation layer and induces additional mechanical stress at the interface between the passivation layer and the SiC, which aggravates the delamination phenomenon previously mentioned.

For example, delamination manifests itself with the bending of the passivation layer with respect to the SiC, detachments of the passivation layer from the SiC starting from the edges of the device, and cracks or apertures in the passivation layer.

Known solutions to this issue envisage using anchoring elements of the passivation layer to the SiC, using alternative and complex structures for the passivation layer and the protection layer, or using alternative materials. However, none of these known solutions effectively solve the delamination issue, making the operation of known devices unreliable. Furthermore, these known solutions generally substantially complicate the final structure of the device and the manufacturing process thereof, increasing its production cost and making it more susceptible to malfunctions.

Document US2024234241A1 relates to a radio frequency (RF) device and a process for making the same, and more particularly to an RF device with nanotube particles for enhanced thermal and electrical performance, and a wafer-level fabricating and packaging process to provide the RF device.

Document WO2023218449A1 relates to heat spreading coating for electronic circuits, more particularly for improving the heat spreading from electronical components while increasing product reliability and reducing the weight and size of the electronical assembly.

Document US2018047652A1 relates to the field of power electronics and more particularly to a power semiconductor device and a method for manufacturing such a power semiconductor device.

The aim of the present invention is to provide an electronic device and a manufacturing process of the electronic device, which overcome the drawbacks of the prior art.

### SUMMARY

According to the present invention, an electronic device and a manufacturing process of the electronic device are provided, as defined in the annexed claims which form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 illustrates, in cross-sectional view, an electronic device according to an embodiment of the present invention;
- Figure 2 shows, in plan view, the electronic device of Figure 1 according to an embodiment of the present invention; and
- Figures 3A-3D show, in cross-sectional view, manufacturing steps of the electronic device of Figure 1, according to an embodiment of the present invention and limitedly to the manufacture of an adhesion layer.

In particular, the Figures are shown with reference to a triaxial Cartesian system defined by an X axis, a Y axis and a Z axis, orthogonal to each other.

In the following description, elements common to the different embodiments have been indicated with the same reference numbers.

### DETAILED DESCRIPTION OF THE INVENTION

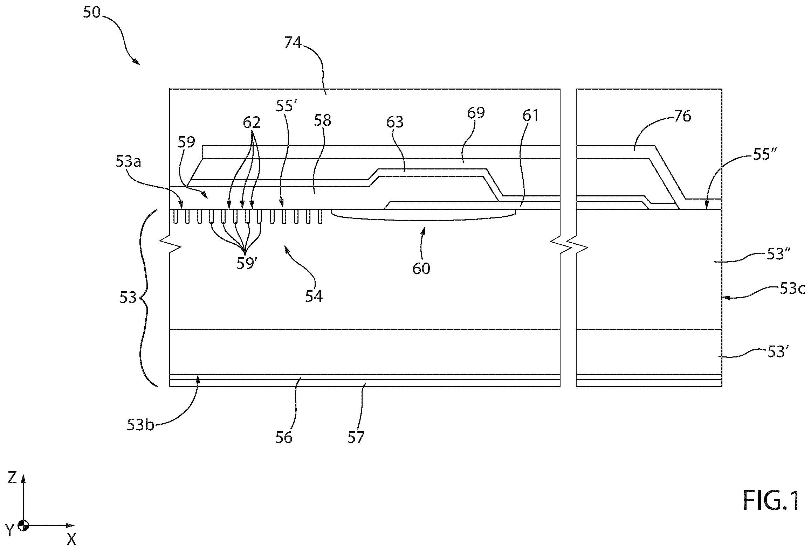

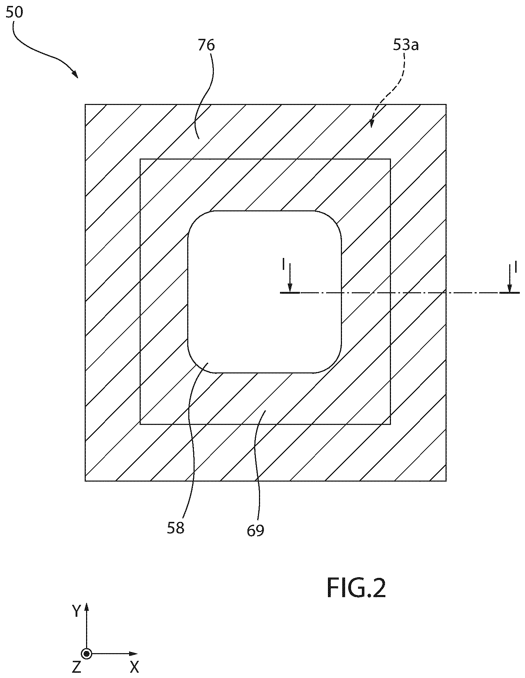

Figure 1 shows, in a lateral sectional view along a section line I-I shown in Figure 2, an electronic device 50 according to an aspect of the present invention.

In particular, the electronic device 50 is a high-power device, i.e. configured to operate at electrical voltages equal to about 650-2200 V and electrical currents equal to about 1-5 A.

In particular, the device 50 is a JBS ("Junction Barrier Schottky") diode; however, the present invention is not limited to such a device and also finds application to other types of electronic devices, in particular power devices, such as for example MOSFET, IGBT, MPS, Schottky diode, PN diode, PiN diode, etc.

The electronic device 50 comprises the elements described hereinbelow, illustrated with reference to Figure 1.

A semiconductor body 53 (e.g., including a substrate 53' and, optionally, one or more epitaxial layers 53" grown thereon), of N-type or P-type SiC (hereinafter, non-limiting reference will be made to the sole N-type), is provided with an upper surface 53a opposite to a rear surface 53b along the direction of the Z axis.

The semiconductor body 53 includes, in the example illustrated in Figure 1, the substrate 53' having the epitaxial layer 53" grown hereon acting as a drift layer of the electronic device 50, both of N-type SiC (in particular 4H-SiC, however other polytypes may be used such as, but not limited to, 2H-SiC, 3C-SiC and 6H-SiC). For example, the substrate 53' has an N-type dopant concentration comprised between 1·10¹⁹ at/cm³ and 1·10²² at/cm³ and has a thickness, measured along the Z axis between the surfaces 53a and 53b, comprised between 300 µm and 450 µm, and in particular equal to about 360 µm. The drift layer 53" has a respective dopant concentration lower than the dopant concentration of the substrate and a thickness comprised, for example, between 5 and 15 µm.

An ohmic contact layer 56 (e.g. of Nickel Silicide) extends on the rear surface 53b, and a metallization 57, in this example a cathode metallization, e.g. of Ti/NiV/Ag or Ti/NiV/Au, extends on the ohmic contact region 56.

One or more doped regions 59' of P-type extend in the semiconductor body 53 (in particular in the drift layer), facing the upper surface 53°.

Each doped region 59' accommodates a respective ohmic contact (not shown and of a known type) such that each doped region 59' forms a respective junction-barrier (JB) element 59.

An edge termination region, or protection ring, 60, in particular a further P-type doped region, extends in the drift layer, faces the upper surface 53a and completely surrounds (in plan view, on an XY plane defined by the axes X and Y) the JB elements 59. The edge termination region 60 may be omitted.

An insulating layer 61 (of insulating or dielectric material, e.g. Silicon Oxide, TEOS) extends on the upper surface 53a in such a way as to completely surround (in view on the XY plane) the JB elements 59 and to be partially superimposed on the protection ring 60 (if any).

A metallization 58, in this example an anode metallization, for example of Ti/AlSiCu or Ni/AlSiCu, extends on a portion of the upper surface 53a externally delimited by the insulating layer 61 (i.e., at the JB elements 59 / active region 54) and, partially, on the insulating layer 61.

A passivation layer 69 of polymeric material such as polyamide (e.g., PIX), extends on the anode metallization 58 and the insulating layer 61.

An interface layer 63, here of Silicon Nitride (SiN), extends above the anode metallization 58 and the insulating layer 61, and below the passivation layer 69. In other words, the interface layer 63 acts as an interface between the passivation layer 69 and the underlying layers, here the metallization 58 and the insulating layer 61, and favors the adhesion of the overlying passivation layer 69.

One or more Schottky diodes 62 are formed at the interface between the semiconductor body 53 and the anode metallization 58, laterally to the doped regions 59'. In particular, (semiconductor-metal) Schottky junctions are formed by portions of the semiconductor layer 53 in direct electrical contact with respective portions of the anode metallization 58.

Furthermore, each ohmic contact extending in the respective doped region 59' forms an electrical connection having an electrical resistivity value lower than the electrical resistivity value of the doped region 59' accommodating it. The JB elements 59 are therefore P-i-N diodes.

The region of the electronic device 50 that includes the JB elements 59 and the Schottky diodes 62 (i.e., the region delimited by the protection ring 60) is an active region (or area) 54 of the electronic device 50.

Externally to the active region 54, i.e. beyond the edge termination region 60, a lateral surface 53c of the semiconductor body 53 is present, for example extending substantially orthogonally to the upper surface 53a.

The lateral surface 53c is formed following a dicing step of a SiC wafer wherein a plurality of electronic devices 50 are formed. The dicing step has the function of separating an electronic device 50 from another device 50 of the same wafer. The dicing occurs at a scribe line (not shown) of the SiC wafer from which the electronic device 50 is obtained; this scribe line surrounds at a distance, in the XY plane, the active region 54, the protection ring 60 and the insulating layer 61.

Hereinafter, the portion (or region) of the upper surface 53a that extends internally to the protection ring 60 and which therefore defines the active region 54 is also referred to as the first portion of the upper surface 53a (and indicated in Figure 1 with the reference 55'), while the portion (or region) of the upper surface 53a that extends externally to the protection ring 60 and which is therefore external to the active region 54 is also referred to as the second portion of the upper surface 53a (and indicated in Figure 1 with the reference 55").

In addition, an adhesion layer (or region) 76 extends above the passivation layer 69.

The adhesion layer 76 may also extend above the upper surface 53a externally to the active region 54, where the upper surface 53a is exposed by the passivation layer 69. In this case, the adhesion layer 76 is in contact with the second portion 55" of the upper surface 53a.

The adhesion layer 76 extends at a distance from the anode metallization 58, so as to be electrically decoupled from the latter (i.e., not to be in electrical contact with the latter).

The adhesion layer 76 is based on one or more carbon allotropes (e.g., graphene, graphite, carbon nanotubes, diamond), in particular it is of one of such carbon allotropes.

In the embodiment exemplarily considered hereinbelow, the adhesion layer 76 is of graphene.

In particular, in the embodiment considered here, the adhesion layer 76 comprises a single graphene layer or a graphene multilayer (or stack) formed with a plurality of graphene layers superimposed on each other (e.g., about 2-10 graphene layers superimposed).

In greater detail, the one or more graphene layers are arranged in such a way as to extend in a manner substantially parallel to the XY plane and therefore to the upper surface 53a (i.e. the lying plane of each graphene layer is substantially parallel to the XY plane).

For example, the adhesion layer 76 has a thickness, along the direction of the Z axis, comprised between about 0.3 nm and about 5 nm.

A protection layer 74, of a resin such as for example Bakelite, extends above the adhesion layer 76 and the anode metallization 58 (where exposed by the passivation layer 69), to protect the electronic device 50 when inserted into a package (not illustrated).

As a result, along the direction of the Z axis, the adhesion layer 76 is interposed (in particular, in direct physical contact) between the passivation layer 69 and the protection layer 74, such as to operate as an interface layer between these two layers.

In detail, it has been verified that the adhesion layer 76 reduces the mechanical coupling between the passivation layer 69 and the protection layer 74, thus decreasing the transmission of stress and strain from one layer to the other. In particular, this is due to the fact that the adhesion layer 76 binds with the passivation layer 69 and the protection layer 74 through van der Waals forces. This allows to reduce the stress applied to the interface between the passivation layer 69 and the underlying semiconductor body 53 and caused by the overall thermal deformation of the passivation layer 69 and the protection layer 74.

Furthermore, it has been verified that the adhesion layer 76 reduces in use the heating of the active region 54, especially when it is made of graphene. In fact, graphene has a high thermal conductivity of the "in-plane" type, i.e. with heat exchange that occurs planarly with respect to the lying plane of the Carbon atoms (e.g., equal to about 2-60 W/mK), and a low thermal conductivity of the "cross-plane" type, i.e. with heat exchange that occurs orthogonally to the lying plane of the Carbon atoms (e.g., equal to about 0.1-0.3 W/mK); this implies that the graphene in the electronic device 50 is an optimum thermal conductor for heat exchanges that occur parallel to the XY plane and is instead poorly thermally conductive for heat exchanges that occur parallel to the Z axis. This allows the adhesion layer 76 to collect the heat generated in use by the electronic device 50 at the active region 54 and to transport it outside the active region 54, where it is dispersed without impacting the operation of the electronic device 50. This prevents the heat generated by the active region 54 from being transmitted to the protection layer 74 or from increasing at the passivation layer 69; consequently, the mechanical strain caused by the heating of these layers is reduced.

Figure 2 schematically shows the electronic device 50 in a top-plan view (on the XY plane), according to an embodiment.

With reference to Figure 2, the adhesion layer 76 extends in the XY plane so as to completely surround the passivation layer 69 and cover it.

In the view in the XY plane of Figure 2, the internal edge of the adhesion layer 76 defines a closed polygonal shape, and in greater detail a square shape with rounded corners (although different shapes are also possible, such as a circular shape, a rectangular shape or a generically polygonal or irregular shape).

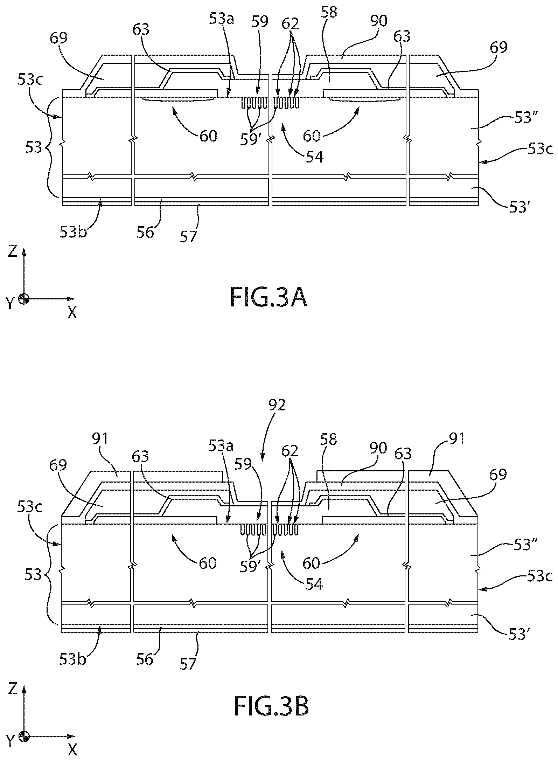

Manufacturing steps of a manufacturing process of the electronic device 50 of Figure 1 are described hereinbelow, with reference to Figures 3A-3D and limitedly to the manufacturing steps of the adhesion layer 76. Figures 3A-3D are represented in the same triaxial system as Figure 1.

With reference to Figure 3A, a wafer is arranged including the semiconductor body 53 of SiC, the insulating layer 61, the anode metallization 58, the interface layer 63 and the passivation layer 69, following manufacturing steps for forming elements of the electronic device 50 previously described (and not further discussed herein as they are known) and identified with the same reference numbers.

In Figure 3A, an adhesion work layer 90 is formed uniformly above the passivation layer 69, the region of the anode metallization 58 that is exposed by the passivation layer 69, and the region of the top surface 53a of the semiconductor body 53 that is exposed by the passivation layer 69 outside the active region 54.

The adhesion work layer 90 is based on one or more carbon allotropes (e.g., graphene, graphite, carbon nanotubes, diamond), in particular it is of one of such carbon allotropes.

In the embodiment exemplarily considered hereinbelow, the adhesion layer 76 is of graphene. In particular, the adhesion layer 76 comprises a single graphene layer or a graphene multilayer (or stack).

The adhesion work layer 90 has, in a direction along the Z axis, a thickness equal to the previously described thickness of the adhesion layer 76.

Thanks to the steps described below, the adhesion work layer 90 will form the adhesion layer 76.

In particular, the adhesion work layer 90 is formed by deposition, for example chemical vapour deposition (CVD).

With reference to Figure 3B, a lithographic mask 91 is formed on the adhesion work layer 90.

The lithographic mask 91 has an opening 92 that is substantially vertically aligned (i.e. superimposed along the direction of the Z axis) with the active region 54. In detail, the opening 92 is vertically aligned with the internal edge of the passivation layer 69, such that the lithographic mask 91 is vertically superimposed on the passivation layer 69 and on the region of the upper surface 53a of the semiconductor body 53 that is exposed by the passivation layer 69 outside the active region 54, while it is not vertically superimposed on the region of the anode metallization 58 that is exposed by the passivation layer 69.

The lithographic mask 91 is for example of photoresist and is formed according to lithography and chemical etching techniques known per se.

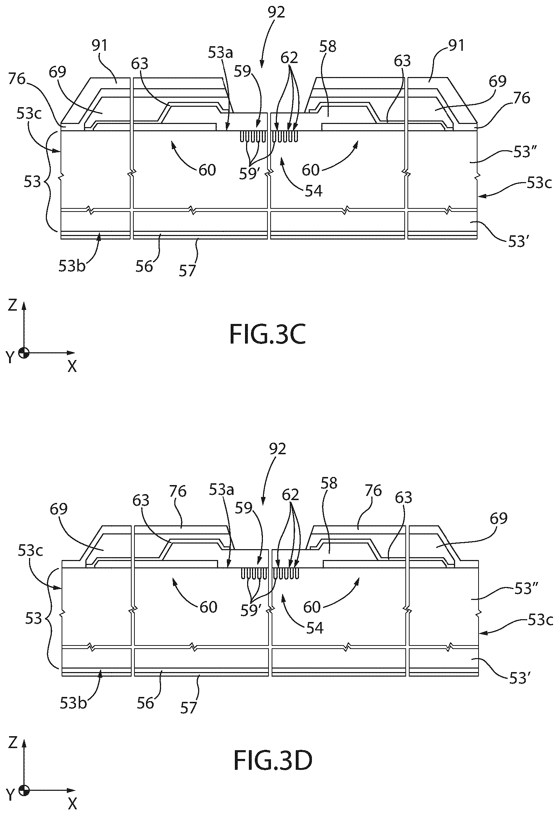

Then, Figure 3C, an etching of the adhesion work layer 90 is performed through the previously formed opening 92, so as to expose the region of the anode metallization 58 that is not covered by the passivation layer 69.

This etching defines the adhesion layer 76 starting from the adhesion work layer 90. In particular, this etching patterns, in view in the XY plane, the closed polygonal shape of the internal edge of the adhesion layer 76.

The etching is, for example, of the dry type and uses an etching chemistry that is selective with respect to the material of the adhesion work layer 90 (e.g., in O₂, N₂), which therefore removes the exposed portion of the adhesion work layer 90 without therefore removing the underlying anode metallization 58 and the lithographic mask 91.

In particular, the etching proceeds as long as the upper surface of the anode metallization 58 is exposed.

Then, Figure 3D, the lithographic mask 91 is removed, in a manner known per se.

Afterwards and in a manner not shown, the protection layer 74 is formed above the adhesion layer 76 and the anode metallization 58, according to techniques also of a known type.

For example, the resin, that is liquid or semi-liquid, is applied on the wafer through "moulding", so that it penetrates through the opening 92 and comes into contact with the anode metallization 58. A thermal process is subsequently performed so that the resin hardens, forming the protection layer 74 (curing process, or in-a-heater process). The resin is, for example, Bakelite.

The manufacturing process then continues with subsequent steps to form further elements of the electronic device 50, not described herein in detail as they are known per se (e.g., the ohmic contact layer 56 and the cathode metallization 57).

From an examination of the characteristics of the invention made according to the present invention, the advantages that it affords are evident.

In particular, the adhesion layer 76 ensures the adhesion of the passivation layer 69 to the underlying semiconductor body 53, preventing delamination phenomena for the reasons better described previously. In particular, this is ensured thanks to the fact that the adhesion layer 76 acts as a heat sink towards the outside of the electronic device 50, preventing the local temperature in the active region 54 from growing excessively, causing the passivation layer 69 to expand excessively and thus causing mechanical stresses at the interface with the semiconductor body 53. These advantages are achieved with any carbon allotrope and in particular are achieved in an optimal manner through the use of graphene, thanks to its excellent thermal conduction properties.

As a result, the risk of damage to the electronic device 50 following electrical discharges between metallizations set to different potentials (e.g., between the EQR metallization and the anode metallization 58) is avoided, and therefore the reliability of the electronic device 50 is increased, in particular when subject to high thermal excursions and operated in reverse bias conditions.

Finally, it is clear that modifications and variations may be made to the invention described and illustrated herein without thereby departing from the scope of the present invention, as defined in the attached claims.

For example, the different embodiments described may be combined with each other to provide further solutions.

## Claims

1. An electronic device (50) comprising:
a semiconductor body (53) of Silicon Carbide, having a surface (53a) having a first portion (55') of the surface (53a) that defines an active region (54) of the electronic device (50) and a second portion (55") of the surface (53a) that is external to the active region (54);
a metallization (58) extending on the first portion (55') of the surface (53a) of the semiconductor body (53);
a passivation layer (69) extending on part of the metallization (58); and
an adhesion layer (76), based on one or more carbon allotropes, extending on the passivation layer (69).

2. The electronic device according to claim 1, further comprising a protection layer (74) extending above the adhesion layer (76) and the metallization (58), where exposed by the passivation layer (69), such that the adhesion layer (76) is interposed between the passivation layer (69) and the protection layer (74) along an axis (Z) that is orthogonal to the surface (53a) of the semiconductor body (53).

3. The electronic device according to claim 1 or 2, wherein the adhesion layer (76) further extends on the second portion (55") of the surface (53a), that is external to the active region (54) and is exposed by the metallization (58) and the passivation layer (69).

4. The electronic device according to claim 3, wherein the adhesion layer (76) is in contact with the second portion (55") of the surface (53a).

5. The electronic device according to any of the preceding claims, wherein the adhesion layer (76) extends at a distance from the metallization (58).

6. The electronic device according to any of the preceding claims, wherein the adhesion layer (76) is of one of the following materials: graphene; graphite; diamond; carbon nanotubes.

7. The electronic device according to claim 6, wherein the adhesion layer (76) is formed by a single graphene layer or by a graphene multilayer formed with a plurality of single graphene layers superimposed on each other.

8. The electronic device according to claim 7, wherein the one or more single graphene layers are arranged at least partially so as to be parallel to the surface (53a) of the semiconductor body (53).

9. The electronic device according to any of the preceding claims, wherein the adhesion layer (76) completely surrounds, parallel to the surface (53a) of the semiconductor body (53), the passivation layer (69) and furthermore, orthogonally to the surface (53a) of the semiconductor body (53), covers the passivation layer (69).

10. The electronic device according to any of the preceding claims, chosen from among the group comprising: a Schottky diode, a PiN diode, a PN diode, an MPS device, a JBS diode, a MOSFET, an IGBT, a power device.

11. The electronic device according to any of the preceding claims, further comprising a protection ring (60) that extends in the semiconductor body (53) from the surface (53a),
wherein the first portion (55') of the surface (53a) extends internally to the protection ring (60) and the second portion (55") of the surface (53a) extends externally to the protection ring (60).

12. A process for manufacturing an electronic device (50), comprising the steps of:
- forming a semiconductor body (53) of Silicon Carbide, having a surface (53a) having a first portion (55') of the surface (53a) for defining an active region (54) of the electronic device (50) and a second portion (55") of the surface (53a) that is external to the active region (54);
- forming a metallization (58) on the first portion (55') of the surface (53a) of the semiconductor body (53);
- forming a passivation layer (69) on part of the metallization (58); and
- forming an adhesion layer (76), based on one or more carbon allotropes, on the passivation layer (69).

13. The manufacturing process according to claim 12, wherein the step of forming the adhesion layer (76) comprises:
- forming an adhesion work layer (90), based on one or more carbon allotropes, above the passivation layer (69), the part of the metallization (58) that is exposed by the passivation layer (69), and the second portion (55") of the surface (53a) that is external to the active region (54);
- forming a lithographic mask (91) on the adhesion work layer (90), the lithographic mask (91) being superimposed on the passivation layer (69) and on the second portion (55") of the surface (53a) and having an opening (92) superimposed on the part of the metallization (58) that is exposed by the passivation layer (69);
- performing a selective etching of the adhesion work layer (90) through the opening (92), so as to expose the part of the metallization (58) that is exposed by the passivation layer (69), the etched adhesion work layer (90) defining the adhesion layer (76); and
- removing the lithographic mask (91).

14. The manufacturing process according to claim 13, wherein the step of forming the adhesion work layer (90) comprises performing a deposition, in particular a chemical vapour deposition, CVD.

15. The manufacturing process according to claim 13 or 14, wherein the step of performing the selective etching comprises performing a dry etching using an etching chemistry that is selective with respect to the material of the adhesion work layer (90).

16. The manufacturing process according to any of claims 12-15, further comprising the step of forming a protection layer (74) above the adhesion layer (76) and the metallization (58), where exposed by the passivation layer (69), such that the adhesion layer (76) is interposed between the passivation layer (69) and the protection layer (74) along an axis (Z) that is orthogonal to the surface (53a) of the semiconductor body (53).
